# EUROPEAN PATENT SPECIFICATION

(11) **EP 0 631 314 B1**
(45) Date of publication and mention of the grant of the patent: **16.09.1998**
(21) Application number: 93830277.5
(22) Date of filing: 28.06.1993
(51) Int. Cl.: H01L 23/485, H01L 23/60, H01L 21/60

(54) **Multiple-metal-level integrated device and fabrication process thereof**
Integriertes Bauelement mit Mehrschichtmetallisierung und Herstellungsverfahren
Dispositif intégré à niveaux métalliques multiples et procédé de fabrication

(43) Date of publication of application: 28.12.1994
(73) Proprietor: STMicroelectronics S.r.l., 20041 Agrate Brianza (Milano) (IT)
(72) Inventor: Caprile, Candida, I-20133 Milano (IT); De Santi, Giorgio, I-20124 Milano (IT)
(74) Representative: Jorio, Paolo, Dr. Ing.

(56) References cited:
- EP-A- 418 777
- EP-A- 519 665
- US-A- 4 714 949
- PATENT ABSTRACTS OF JAPAN vol. 10, no. 329 (E-452)(2385) 8 November 1986 & JP-A-61 136 251 ( MATSUSHITA ELECTRONICS CORP. ) 24 June 1986
- PATENT ABSTRACTS OF JAPAN vol. 10, no. 205 (E-420)(2261) 17 July 1986 & JP-A-61 046 056 ( NEC CORP. ) 6 March 1986
- PATENT ABSTRACTS OF JAPAN vol. 11, no. 359 (E-559)(2806) 21 November 1987 & JP-A-62 134 953 ( NEC CORP. ) 18 June 1987

## Description

The present invention relates to a multiple-metal-level integrated device and fabrication process thereof, according to the preamble of claim 1 and, respectively, claim 3.

As known, when fabricating integrated devices comprising thin oxide layers, these are subject to damage at various stages of the dry etching processes, thus impairing the efficiency and/or reliability of the devices.

Especially critical is the plasma etching process for forming the contacts between the lower metal levels and the upper level. On multiple-metal-level devices, in fact, the bottom layers are contacted by means of an electric connecting structure through the intermediate insulating layers. In particular, in the areas in which the electric contacts of the device are formed, the underlying metal levels are patterned into bonding pads of appropriate and fairly extensive area, and the contacts are formed by plasma etching the intermediate dielectric layers over the pads, so as to form openings with a cross section of slightly less than the pad area, and then depositing a metal layer to fill the openings and form the contact.

Plasma etching the contacts towards the first metal level is especially critical by virtue of the first level, at which etching is stopped, contacting the thin oxide layers (less than 150 Å thick for tunnel oxides, and not much thicker for gate oxides), and being connected to the upper armatures of the capacitors. The extensive contact area of the bonding pads permits capture by the metal pad of a substantial electric charge (antenna effect) highly capable of resulting in electrostatic discharge through the thin oxide layers.

To safeguard the thin oxides against electric discharge, provision is currently made for structures formed on the same die and designed to absorb high voltage peaks without transferring them to the active circuits. Such structures, however, are not provided on process characterization test devices, particularly for direct measurement of the deficiency and reliability of the oxide layers, so that, in these cases at least, other techniques are required for safeguarding the oxide layers during fabrication. In general, however, straightforward structures are desirable, capable of eliminating or at least partly solving the problem of electrostatic discharge resulting from the capture of electric charges.

An integrated device of the type defined in the preamble of claim 1 is disclosed in EP-A-0 519 665, wherein, for planarizing a multi-layer metal bonding, a contact structure is proposed, including a plurality of metal layers and interposed dielectric layers having a multitude of vias. The vias extend at the entire surface of the pad. also under the contact opening in the protection layer. Thus this known device does not solve the above explained problem of electrostatic discharge.

The object of the present invention is to avoid these disadvantages

It is an object of the present invention to provide a device and fabrication process thereof designed to solve the above problem.

According to the present invention, there is provided a device as claimed in Claim 1.

According to the present invention, there is also provided an integrated device fabrication process as claimed in Claim 3.

A preferred, non-limiting embodiment of the present invention will be described by way of example with reference to the accompanying drawings, in which:
Fig.1 shows a plan view of a portion of one embodiment of an integrated device in accordance with the present invention;
Fig.2 shows a cross section of the Fig.1 device.

Number 1 in the accompanying drawings indicates an integrated device of which is shown only the portion wherein a metal line forming part of the first metal level is connected.

Device 1 comprises in known manner a substrate 2 of semiconductor material underlying an oxide layer 3 fully surrounding, at least in the portion shown, a metal line 4 terminating at a first pad 5 of a given area (typically 50-150 µm square). Metal line 4 and pad 5 form part of a first metal level indicated as a whole by 6.

Over oxide layer 3, there is provided a second pad 7 forming part of a second metal level (indicated as a whole by 8), and located over and of substantially the same area as first pad 5. According to the present invention, pads 5 and 7 are mutually connected by a number of small-area contact regions 10 through oxide layer 3, and the size of which (ranging from 0.5 to 3 µm) depends on the fabrication process employed. Over second metal level 8, there is provided a passivation layer 12 having an opening 13 at top pad 8, for welding the pad by means of a wire (not shown) to a pin (not shown) at the final assembly stage.

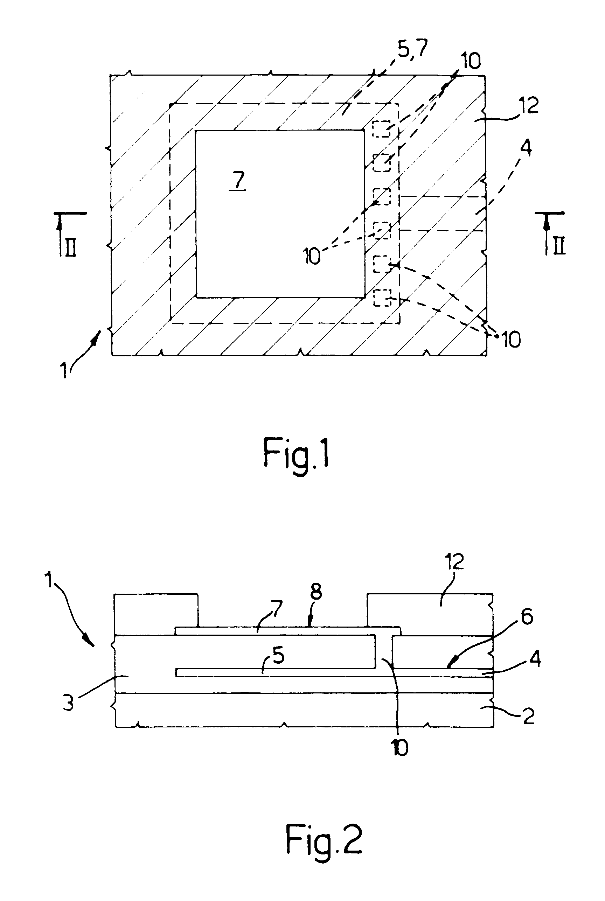

As shown particularly in Fig.2, contact regions 10 (also known as "vias") are located close to the edge of pads 5, 7 for protection by the final passivation layer; and are aligned parallel and close to the edge from which metal line 4 originates, so as to enable uniform distribution of the injected current and prevent current crowding.

The number of vias 10 depends on the maximum current of the structures connected over metal line 4 to pad 5. In general, the current density of vias made of aluminium alloy based metal is necessarily 2x10⁵ A/cm², and may be as high as 1x10⁶ A/cm² for tungsten plugged types.

The process for fabricating the Fig.1-2 structure is as follows.

After being deposited in known manner, the first metal layer is masked and etched to form, in addition to the connecting lines, first-level pads 5 of conventional size and in normal manner. Using known deposition, heat treatment and etching techniques, the insulating layer between the two metal levels is then formed, and together with the oxide layer beneath the first metal level, forms layer 3.

At this point, the vias between the two metal levels are opened by masking and subsequent etching. Thereby, according to the present invention, for each pad 5 a number of openings are formed, terminating at first pad 5, on the side from which the respective metal line originates, as already described. A metal layer is then deposited to fill the openings and produce vias 10 and, possibly, second metal level 8, and is subsequently masked to form the second-level metal lines (not shown) and top pads 7.

Finally, passivation layer 12 is deposited and subsequently masked and patterned to expose top pads 7, with the exception of the periphery, and more specifically the portions overlying and protecting vias 10, to give the structure shown in the drawings.

The advantages of the device and fabrication process according to the present invention will be clear from the foregoing description. Firstly, by virtue of contact between the two metal levels being achieved by means of a number of regions, the total area of which is considerably less than that of the respective pads (the area ratio of the pads and vias 10 typically ranges between 0.001 and 0.01), the possibility of electric charges being captured during the critical stages, particularly when plasma etching the vias, is drastically reduced. Secondly, location of the vias along the edge of the pads provides for protecting them by means of the passivation layer during the final fabrication stages of the device; while, as already stated, location along the side from which the respective metal line originates prevents current crowding. Thirdly, the structure as described involves no complex, high-cost alterations to fabrication processes or machinery, the fabrication process in fact requiring only redesigning of the mask for opening the vias. Finally, the solution described is both straightforward and reliable.

To those skilled in the art it will be clear that changes may be made to the device and process as described and illustrated herein without, however, departing from the scope of the present invention. In particular, the number and area of the vias may vary depending on current flow, the materials used, and achievable process dimensions.

## Claims

1. A multiple-metal-level integrated device (1) comprising:
- a substrate (2) of semiconductor material;
- at least one first metal level (6) overlying said substrate (2) and defining at least one metal line (4) terminating in a first contact pad (5), said first contact pad (5) being polygonal and presenting a perimeter;
- a second metal level (8) defining at least one second contact pad (7) substantially overlying said first contact pad (5); and
- a protection layer (12) extending over said second metal level (8) and having at least one opening at said second contact pad (7);
said first and second contact pads (5, 7) being separated by a layer of insulating material (3) and being connected electrically by a contact structure (10) extending through said layer of insulating material and between said first and second contact pads, said contact structure comprising a number of parallel contact regions (10) having a much smaller cross sectional area as compared with said first and second contact pads (5, 7),
characterized in that all said contact regions (10) are located close to said perimeter, beneath said protection layer (12), and are offset laterally with respect to said opening such that portions of said protection layer overlie said contact regions.

2. A device as claimed in Claim 1, wherein said polygon of said first contact pad (5) comprises a side with which blends said at least one metal line (4); characterized in that said contact regions (10) terminate close to said side of said polygon.

3. A process for fabricating an integrated device (1) as claimed in one of the foregoing Claims, said process comprising the steps of:
- forming, over a substrate (2) of semiconductor material, a first metal level (6) comprising at least one metal line (4) terminating in a first contact pad (5) shaped into a polygon having a perimeter
- forming a layer of insulating material (3) over said first metal level;
- forming, over said layer of insulating material, a second metal level comprising at least one second contact pad (7) substantially overlying said first contact pad; and
- forming, through said layer of insulating material, a contact structure (10) extending between and electrically connecting said first and second contact pads (5, 7), said contact structure comprising a number of parallel contact regions (10) having a much smaller cross sectional area as compared with said first and second pads (5, 7),
- forming a protection layer (12) extending over said second metal layer (8) and having at least one opening at said second contact pad (7);
wherein said steps of forming said second metal level (8) and said contact structure (10) comprise the steps of forming, in said layer of insulating material (3), a number of openings having a much smaller area as compared with said first contact pad (5) and extending up to said first pad; depositing a metal layer (8) to fill said openings; and patterning said metal layer to form said second contact pad (7), characterized in that all said contact regions (10) are located close to said perimeter, beneath said protection layer (12), and are offset laterally with respect to said opening such that portions of said protection layer overlie said contact regions.

4. A process according to claim 3, characterized in that said polygon of said first contact pad (5) comprises a side blending with said at least one metal line (4) and in that said contact regions (10) terminate close to said side of said polygon.

## Patentansprüche

1. Integriertes Bauelement (1) mit Mehrschicht-Metallisierung, welches aufweist:
- ein Substrat (2) aus einem Halbleitermaterial;
- zumindest eine erste Metallschicht (6) über dem Substrat (2) liegend und zumindest eine Metalleitung (4) definierend, welche in einem ersten Kontaktfleck (5) endet, wobei der erste Kontaktfleck (5) polygonal ist und einen Umfang aufweist;
- eine zweite Metallschicht (8) zum Definieren von zumindest einem zweiten Kontaktfleck (7), welcher im wesentlichen über dem ersten Kontaktfleck (5) liegt; und
- eine Schutzschicht (12), welche über der zweiten Metallschicht (8) läuft und zumindest eine Öffnung an dem zweiten Kontaktfleck (7) aufweist;
wobei der erste und zweite Kontaktfleck (5, 7) durch eine Schicht aus Isoliermaterial (3) getrennt sind und elektrisch durch eine Kontaktstruktur (10) verbunden sind, welche durch die Schicht aus Isoliermaterial und zwischen dem ersten und zweiten Kontaktfleck verläuft, wobei die Kontaktstruktur eine Anzahl paralleler Kontaktbereiche (10) aufweist, welche einen wesentlich kleineren Querschnittsbereich als der erste und zweite Kontaktfleck (5, 7) aufweisen, dadurch gekennzeichnet, daß alle Kontaktbereiche (10) nahe dem Umfang, unter der Schutzschicht (12) und lateral bezüglich der Öffnung versetzt angeordnet sind, so daß Bereiche der Schutzschicht über den Kontaktbereichen liegen.

2. Vorrichtung nach Anspruch 1, dadurch gekennzeichnet, daß das Polygon des ersten Kontaktflecks (5) eine Seite aufweist, welche die zumindest eine Metalleitung (4) verblendet, dadurch gekennzeichnet, daß die Kontaktbereiche (10) nahe der Seite des Polygons enden.

3. Verfahren zum Herstellen eines integrierten Bauelements (1) nach einem der vorhergehenden Ansprüche, wobei das Verfahren folgende Schritte aufweist:
- Bilden über einem Substrat (2) aus einem Halbleitermaterial, einer ersten Metallschicht (6) mit zumindest einer Metalleitung (4), welche in einem ersten Kontaktfleck (5) endet, der eine polygonale Gestalt aufweist und einen Umfang aufweist;
- Bilden einer Schicht aus Isoliermaterial (3) über der ersten Metallschicht;
- Bilden über der Schicht aus Isoliermaterial einer zweiten Metallschicht mit zumindest einem zweiten Kontaktfleck (7), welcher im wesentlichen über dem ersten Kontaktfleck liegt; und
- Bilden über der Schicht aus Isoliermaterial einer Kontaktstruktur (10), welche zwischen dem ersten und zweiten Kontaktfleck (5, 7) verläuft und diese elektrisch verbindet, wobei die Kontaktstruktur eine Anzahl von parallelen Kontaktbereichen (10) aufweist, welche eine wesentlich geringere Querschnittsfläche aufweisen als der erste und zweite Kontaktfleck (5, 7);
- Bilden einer Schutzschicht (12), welche über der zweiten Metallschicht (8) verläuft und zumindest eine Öffnung an dem zweiten Kontaktfleck (7) aufweist;
wobei die Schritte des Bildens der zweiten Metallfläche (8) und der Kontaktstruktur (10) die Schritte des Bildens einer Anzahl von Öffnungen in der Schicht aus Isoliermaterial (3) mit einer wesentlich kleineren Fläche als dem ersten Kontaktfleck (5), welche bis zum ersten Kontaktfleck laufen; Abscheiden einer Metallschicht (8) zum Füllen der Öffnungen; und Strukturieren der Metallschicht zum Bilden des zweiten Kontaktflecks (7) aufweisen, dadurch gekennzeichnet, daß alle Kontaktbereiche (10) nahe dem Umfang, unterhalb der Schutzschicht (12) und lateral versetzt bezüglich der Öffnung angeordnet sind, so daß Bereiche der Schutzschicht über den Kontaktbereichen liegen.

4. Verfahren nach Anspruch 3, dadurch gekennzeichnet, daß das Polygon des ersten Kontaktflecks (5) eine Seitenverblendung mit der zumindest einen Metalleitung (4) aufweist und daß die Kontaktbereiche (10) nahe der Seite des Polygons enden.

## Revendications

1. Dispositif intégré à niveaux métalliques multiples (1), comprenant :
- un substrat (2) de matériau semi-conducteur;
- au moins un premier niveau métallique (6) recouvrant ledit substrat (2) et définissant au moins une ligne métallique (4) se terminant en une première pastille de contact (5), ladite première pastille de contact (5) étant polygonale et présentant un périmètre;
- un deuxième niveau métallique (8) définissant au moins une deuxième pastille de contact (7) disposée sensiblement au-dessus de ladite première pastille de contact (5); et
- une couche de protection (12) s'étendant sur ledit deuxième niveau métallique (8) et ayant au moins une ouverture au niveau de ladite deuxième pastille de contact (7);
lesdites première et deuxième pastilles de contact (5, 7) étant séparées par une couche de matériau isolant (3) et étant connectées électriquement par une structure de contact (10) qui s'étend à travers ladite couche de matériau isolant et entre lesdites première et deuxième pastilles de contact, ladite structure de contact comprenant plusieurs régions de contact parallèles (10) qui ont une section transversale d'une surface beaucoup plus petite que celle desdites première et deuxième pastilles de contact (5, 7),
caractérisé en ce que toutes lesdites régions de contact (10) sont situées à proximité dudit périmètre, sous ladite couche de protection (12), et sont décalées latéralement par rapport à ladite ouverture, de telle sorte que des parties de ladite couche de protection recouvrent lesdites régions de contact.

2. Dispositif selon la revendication 1, dans lequel ledit polygone de ladite première pastille de contact (5) comprend un côté avec lequel se fond ladite au moins une ligne métallique (4); caractérisé en ce que lesdites régions de contact (10) se terminent à proximité dudit côté dudit polygone.

3. Procédé de fabrication d'un dispositif intégré (1) selon l'une des revendications précédentes, ledit procédé comprenant les étapes consistant à :
- former, sur un substrat (2) de matériau semi-conducteur, un premier niveau métallique (6) comprenant au moins une ligne métallique (4) se terminant en une première pastille de contact (5) mise sous la forme d'un polygone ayant un périmètre;
- former une couche de matériau isolant (3) sur ledit premier niveau métallique;
- former, sur ladite couche de matériau isolant, un deuxième niveau métallique comprenant au moins une deuxième pastille de contact (7) disposées sensiblement au-dessus de ladite première pastille de contact; et
- former, à travers ladite couche de matériau isolant, une structure de contact (10) s'étendant entre lesdites première et deuxième pastilles de contact (5, 7) et les connectant électriquement, ladite structure de contact comprenant plusieurs régions de contact parallèles (10) ayant une section transversale d'une surface beaucoup plus petite que celles desdites première et deuxième pastilles (5, 7);
- former une couche de protection (12) s'étendant sur ledit deuxième niveau métallique (8) et ayant au moins une ouverture au niveau de ladite deuxième pastille de contact (7);
dans lequel lesdites étapes consistant à former ledit deuxième niveau métallique (8) et ladite structure de contact (10) comprennent les étapes consistant à former, dans ladite couche de matériau isolant (3), plusieurs ouvertures ayant une surface beaucoup plus petite que ladite première pastille de contact (5) et s'étendant jusqu'à ladite première pastille; à déposer une couche métallique (8) afin de remplir lesdites ouvertures; et à former un motif dans ladite couche métallique afin de former ladite deuxième pastille de contact (7),
caractérisé en ce que toutes lesdites régions de contact (10) sont situées à proximité dudit périmètre, sous ladite couche de protection (12), et sont décalées latéralement par rapport à ladite ouverture de telle sorte que des parties de ladite couche de protection recouvrent lesdites régions de contact.

4. Procédé selon la revendication 3, caractérisé en ce que ledit polygone de ladite première pastille de contact (5) comprend un côté se fondant avec ladite au moins une ligne métallique (4), et en ce que lesdites régions de contact (10) se terminent à proximité dudit côté dudit polygone.
